Europäisches Patentamt

(19) European Patent Office

Office européen des brevets

(11) Publication number: **0 113 590**
**B1**

(12) **EUROPEAN PATENT SPECIFICATION**

(45) Date of publication of patent specification: **15.11.89**

(51) Int. Cl.⁴: **H 03 K 3/023**

(21) Application number: **83308013.8**

(22) Date of filing: **29.12.83**

(54) Semiconductor timer.

(30) Priority: **29.12.82 JP 229266/82**

(43) Date of publication of application:
**18.07.84 Bulletin 84/29**

(45) Publication of the grant of the patent:
**15.11.89 Bulletin 89/46**

(84) Designated Contracting States:
**DE FR GB**

(56) References cited:
**DE-A-2 522 463**
**DE-A-2 720 492**
**US-A-4 017 747**

**IEEE JOURNAL OF SOLID-STATE CIRCUITS,
vol. SC-16, no. 4, August 1981, pages 412-414,
New York, US; K. MARTIN: "A voltage-
controlled switched-capacitor relaxation
oscillator"**

**ELEKTRONIK, vol. 22, no. 5, May 1973, pages
182-184, München, DE; J. GIES: "Ein einfacher
Funktionsgenerator zum Selbstbau"
ELECTRICAL DESIGN NEWS, vol. 18, no. 5, 5th
March 1973, pages 54-58, Denver, US; E.R.**

(73) Proprietor: **FUJITSU LIMITED**
**1015, Kamikodanaka Nakahara-ku
Kawasaki-shi Kanagawa 211 (JP)**

(72) Inventor: **Arakawa, Hideki**
**Asahi-so 13-17, Umegaoka Midori-ku
Yokohama-shi Kanagawa 227 (JP)**
Inventor: **Kawashima, Hiromi**
**Fujitsu Dai-3 Fujigaoka-ryo 2-1-2, Fujigaoka
Midori-ku Yokohama-shi Kanagawa 227 (JP)**

(74) Representative: **Rackham, Stephen Neil et al
GILL JENNINGS & EVERY 53-64 Chancery Lane
London WC2A 1HN (GB)**

(56) References cited:
**HNATEK: "Put the IC timer to work in a myriad
of ways"**

**RADIO FERNSEHEN ELEKTRONIK, vol. 29, no.
8, 1980, page 528, Berlin, DD; G. TURINSKY:
"Zeitgeberschaltung mit impulsformiger
Ladespannung"**

## Description

The present invention relates to a semiconductor timer, particularly to a timer circuit formed on a metal oxide semiconductor (MOS) integrated circuit.

In certain MOS integrated circuits, it is necessary to provide a timer circuit which can set a long time interval. For example, an electrically erasable and programmable read only memory (EEPROM) in general requires timer circuits having a time interval of about 10 to 20 msec for erasing and writing operations. According to the prior art, since such a time interval is produced by a time delay of a continuously charged or discharged CR circuit, a capacitor having a very high capacitance, for example, about 5600 pF, is required. Such a capacitor cannot be formed by a semiconductor, so an external capacitor having a very high capacitance is attached to the integrated circuit. However, this requires the integrated circuit to have an additional connecting pin, and adds to the work of the manufacturer.

Furthermore, where the EEPROM has the functions of automatically erasing, writing, and performing verification, timer circuits or delay circuits having a time interval of about 3 to 5 msec are required to produce each control pulse. According to the prior art, since such timer circuits or delay circuits are formed by a continuously charged or discharged CR circuit consisting of a depletion mode transistor and a MOS capacitor in the MOS integrated circuit, the sizes of the depletion mode transistor and MOS capacitor become very large. Particularly, the size of the MOS capacitor becomes extremely large. For example, a timer circuit having a time interval of 3 msec requires a depletion mode transistor having a size of about W/L=5 µm/500 µm and a MOS capacitor having a size of about W/L=500 µm/500 µm, where W indicates a channel width and L indicates a channel length of the MOS transistor.

It is therefore an object of the present invention to provide a semiconductor timer which can be constructed in a MOS integrated circuit in a small size.

DE—A—2720492 describes a circuit which produces signals of an amplitude greater than the amplitude of a given periodic signal and which includes a first capacitor; a charge circuit connected to the first capacitor for charging the first capacitor; and a discharge circuit connected to the first capacitor for discharging the first capacitor, the discharge circuit including a transistor connected to the first capacitor in parallel and having a gate. The circuit is used for delivering pulses to a load e.g. an IGFET transistor operating an alphanumeric display or dial of an electronic wristwatch.

According to this invention a semiconductor timer includes such a circuit and is characterised in that the discharge circuit also includes a second capacitor connected to the gate of the transistor, and a second transistor connected either between the gate of the first transistor and earth or to the terminal of the second capacitor opposite the terminal connected to the gate of the first transistor, the second capacitor receiving clock pulses and intermittently turning the transistor ON in response to the clock pulses to gradually discharge the first capacitor in response to the clock pulses and in that the timer includes means for monitoring a voltage across the first capacitor and applying a first electrical signal to the gate of the second transistor to enable the clock pulses to start the discharge operation of the discharge circuit.

In this way a long time interval can be set without increasing the size of the first capacitor. For example, a timer having a time interval of about 3 msec can be constructed with a MOS capacitor having a size smaller than W/L=50 µm/50 µm.

The semiconductor timer according to the present invention is useful to set an erasing time period and writing time period of an EEPROM, or to set a time interval of several msec for another job, especially in a computer system.

Figure 1a is a circuit diagram of a discharge circuit used in the present invention;

Figure 1b is an equivalent circuit diagram of the diagram shown in Figure 1a;

Figure 1c is a wave-form diagram illustrating a relationship between clock pulses and gate voltage;

Figure 2 is a circuit diagram of an embodiment of the present invention;

Figure 3 is a wave-form diagram illustrating an operation of the embodiment shown in Figure 2;

Figure 4 is a circuit diagram of a part of a discharge circuit used in the present invention;

Figure 5 is a circuit diagram of another embodiment of the present invention;

Figure 6 is a wave-form diagram illustrating an operation of the embodiment shown in Figure 5;

Figure 7 is a circuit diagram of a circuit for stabilizing the amplitude of the clock pulses; and

Figure 8 is a circuit diagram of a further embodiment of the present invention.

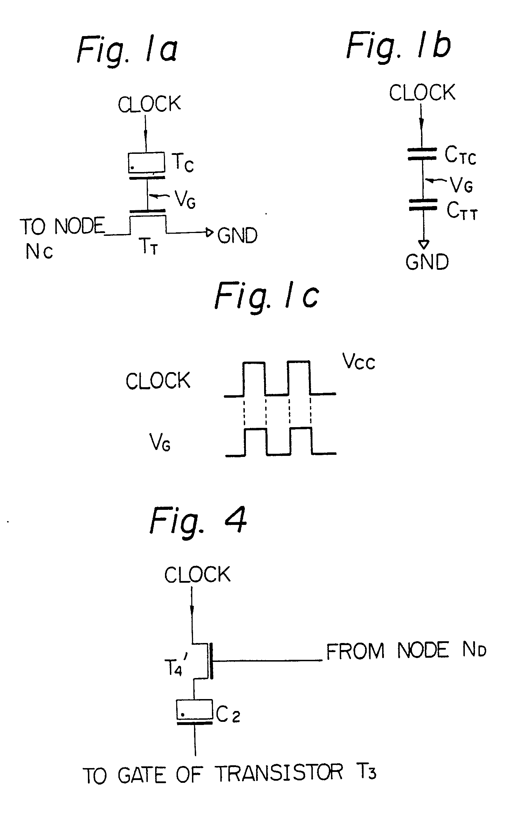

Figure 1a illustrates an example of a discharge circuit in a semiconductor timer of the present invention. In Figure 1a, reference symbol $T_T$ denotes an enhancement mode transistor. The drain of the transistor $T_T$ is connected to a node $N_C$ whereto a first MOS capacitor (not shown) is connected. The source of the transistor $T_T$ is grounded, and the gate of the transistor $T_T$ is connected to one terminal of a second MOS capacitor $T_C$. The other terminal of the capacitor $T_C$ is connected to a clock generator (not shown) to receive clock pulses from the clock generator. In response to the clock pulses, the second MOS capacitor $T_C$ applies a voltage $V_G$, which is higher than the threshold voltage $V_{th}$ of the enhancement mode transistor $T_T$, to the gate of the enhancement mode transistor $T_T$. Thus, the transistor $T_T$ is intermittently turned on to gradually discharge the first MOS capacitor.

Figure 1b illustrates an equivalent circuit of the discharge circuit shown in Figure 1a. Equivalent capacitors $C_{TC}$ and $C_{TT}$ correspond to the second MOS capacitor $T_C$ and the transistor $T_T$, respectively. A relationship between the clock pulses and the voltage $V_G$ at the gate of the enhancement mode transistor $T_T$ is as shown in Figure 1c. The capacitances $C_{TC}$ and $C_{TT}$ of the equivalent capacitors $C_{TC}$ and $C_{TT}$ shown in Figure 1b are defined as

$$C_{TC}=\varepsilon_{ox} \cdot \varepsilon_o \cdot L_{TC} \cdot W_{TC}\, t_{ox} \qquad (1)$$

$$C_{TT}=\varepsilon_{ox} \cdot \varepsilon_o \cdot L_{TT} \cdot W_{TT}/t_{ox} \qquad (2)$$

where $\varepsilon_{ox}$ is the relative permittivity of the gate oxide layer, $\varepsilon_o$ is the permittivity of free space, $t_{ox}$ is the thickness of the gate oxide layer, $L_{TC}$ and $L_{TT}$ are the channel length of the transistor constituting the MOS capacitor $T_C$ and of the enhancement mode transistor $T_T$, and $W_{TC}$ and $W_{TT}$ are the channel width of the above transistors. The voltage $V_G$ at the gate of the enhancement mode transistor $T_T$ when the clock pulses become the voltage $V_{cc}$ is defined as

$$V_G=\frac{C_{TC}}{C_{TC}+C_{TT}} \cdot V_{cc} \qquad (3)$$

Therefore, the voltage $V_G$ at the gate of the transistor $T_T$ when the clock pulses become the voltage $V_{cc}$ can be easily determined to a voltage higher than the threshold voltage $V_{th}$ of the enhancement mode transistor $T_T$, by designing the channel length $L_{TC}$ and the channel width $W_{TC}$ of the MOS capacitor $T_C$ to appropriate values.

The enhancement mode transistor $T_T$ will be turned on when the clock pulses become the voltage $V_{cc}$, causing the charge in the first MOS capacitor to discharge very slowly. As a result, the size of the first MOS capacitor can be reduced.

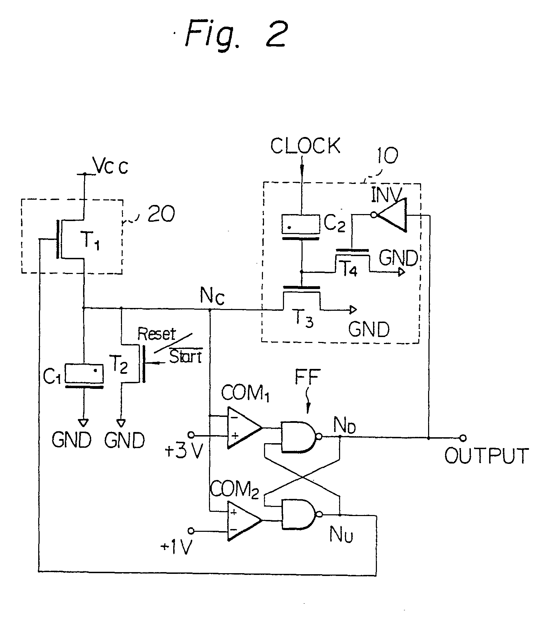

Figure 2 illustrates an embodiment of the present invention, in which the discharge circuit shown in Figure 1a is used. In Figure 2, reference numeral 10 indicates a discharge circuit, and 20 indicates a charge circuit. The discharge and charge circuits 10 and 20 are connected to one terminal (node $N_c$) of a first MOS capacitor $C_1$. The other terminal of the first MOS capacitor $C_1$ is grounded. One terminal of each of the first and second comparators $COM_1$ and $COM_2$ is connected to one terminal (node $N_c$) of the first MOS capacitor $C_1$. The first comparator $COM_1$ compares the voltage $V_{NC}$ at the node $N_c$ with a constant reference voltage of 3 V, and the second comparator $COM_2$ compares the voltage $V_{NC}$ with a constant reference voltage of 1 V. The output terminals of the first and second comparators $COM_1$ and $COM_2$ are connected to input terminals of a flip-flop FF of a negative edge trigger type, respectively. One output terminal (node $N_D$) is connected to the discharge circuit 10, and the other output terminal (node $N_U$) is connected to the charge circuit 20. The output of this timer is obtained, for example, from the node $N_D$. It is apparent that the output of the timer may be obtained from the node $N_U$. A transistor $T_2$ for resetting and starting the timer is connected in parallel with the first MOS capacitor $C_1$.

The discharge circuit 10 comprises a second MOS capacitor $C_2$ which corresponds to the second MOS capacitor $T_C$ shown in Figure 1a, an enhancement mode transistor $T_3$ which corresponds to the transistor $T_T$ in Figure 1a, a transistor $T_4$ connected between the gate of the transistor $T_3$ and the earth, and an inverter INV connected between the gate of the transistor $T_4$ and the node $N_D$.

The charge circuit 20 comprises a transistor $T_1$ connected between a voltage supply (not shown), for supplying the power supply voltage $V_{cc}$, and the node $N_c$. The gate of the transistor $T_1$ is connected to the node $N_U$.

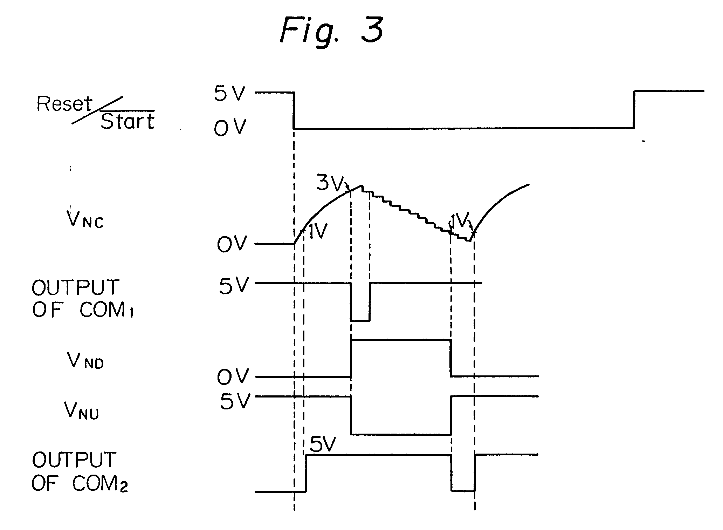

Figure 3 illustrates wave-forms at various points in the embodiment shown in Figure 2. Hereinafter, the operation of the embodiment in Figure 2 will be described with reference to Figure 3.

During a reset condition, since the transistor $T_2$ is in an on state, the voltage $V_{NC}$ at the node $N_c$, which voltage is equivalent to a voltage across the first MOS capacitor $C_1$, is zero (0 V). Therefore, the output of the first comparator $COM_1$ is "H" level (5 V) and the output of the flip-flop, namely the voltage $V_{NU}$ at the node $N_U$, is also "H" level (5 V). As a result, the transistor $T_1$ is in an on state. Furthermore, since the voltage $V_{ND}$ at the node $N_D$ is "L" level, the transistor $T_4$ is in an on state and, thus, the transistor $T_3$ is maintained in an off state during the reset condition.

From the above reset condition, if a reset/start signal Reset/Start changes to "L" level (0 V) and thus the transistor $T_2$ is turned off, the charging operation of the first MOS capacitor $C_1$ starts. Namely, current is fed to the first MOS capacitor $C_1$ via the transistor $T_1$. Thus, the voltage $V_{NC}$ at the node $N_c$ increases, as shown in Figure 3. When the voltage $V_{NC}$ exceeds 3 V, the output of the first comparator $COM_1$ changes from "H" level to "L" level, causing the outputs $V_{ND}$ and $V_{NU}$ of the flip-flop FF to change from "L" level to "H" level and from "H" level to "L" level, respectively, as shown in Figure 3. As a result, the transistor $T_1$ is turned off and the transistor $T_4$ is turned off, causing the discharging operation of the first MOS capacitor $C_1$ to start. Namely, since the transistor $T_1$ is turned off, the charging operation of the first MOS capacitor $C_1$ will stop. On the other hand, since the transistor $T_4$ is off, the voltage $V_G$ at the gate of the transistor $T_3$ momentarily increases each time a clock pulse having a predetermined frequency is applied to the second MOS capacitor $C_2$, causing the transistor $T_3$ to intermittently turn on in response to the clock pulses. Therefore, the first MOS capacitor $C_1$ is gradually discharged.

When the voltage $V_{NC}$ decreases lower than 1 V, the output of the second comparator $COM_2$ changes from "H" level to "L" level, causing the outputs $V_{ND}$ and $V_{NU}$ of the flip-flop FF to change from "H" level to "L" level and from "L" level to "H" level, respectively. As a result, the transistor $T_1$ is turned on to start the charging operation with respect to the first MOS capacitor $C_1$, and the transistor $T_4$ is turned on to ground the gate of the transistor $T_3$, causing the transistor $T_3$ to be maintained in an off state.

According to the above embodiment, the voltage $V_{NC}$ across the first MOS capacitor $C_1$ gradually changes between +3 V and +1 V. Thus, a long time interval of 3 msec can be obtained for the charging and discharging operations by using a first capacitor $C_1$ having a small size of about W/L=50 μm/50 μm.

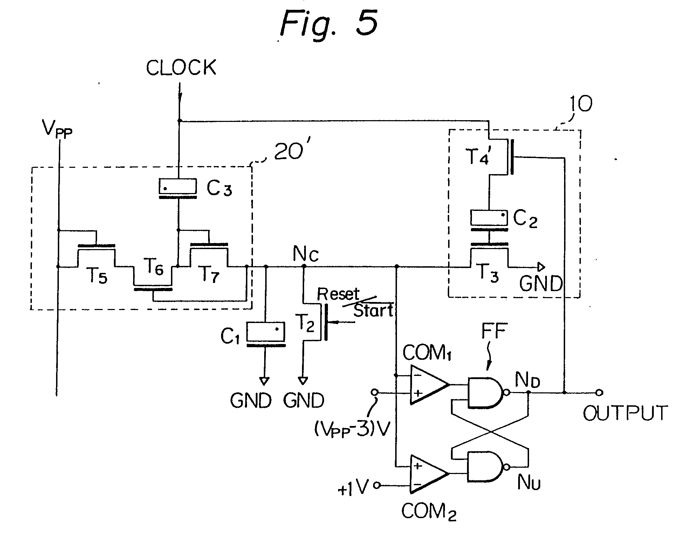

Figure 4 illustrates a part of another example of the discharge circuit 10 in Figure 2. In this example, a transistor $T_4'$ is inserted between the second MOS capacitor $C_2$ and the clock generator (not shown), instead of between the transistor $T_4$ and the inverter INV in the circuit shown in Figure 2. During a reset condition and charging operation, the transistor $T_4'$ is off, and the clock pulses are not applied to the second MOS capacitor $C_2$, causing the transistor $T_3$ (Figure 2) to be maintained in an off state.

Figure 5 illustrates another embodiment of the present invention, in which the discharge circuit 10 in Figure 4 is used, and a charge circuit 20' different from that shown in the embodiment in Figure 2 is used. Furthermore, in this embodiment, a high voltage $V_{PP}$ is used for charging the first MOS capacitor $C_1$.

The charge circuit 20' is composed of a charge pump circuit which comprises a third MOS capacitor $C_3$ and transistors $T_5$, $T_6$, and $T_7$. The gate and drain of the transistor $T_7$ and the source of the transistor $T_6$ are connected to one terminal of the third MOS capacitor $C_3$. The other terminal of the third MOS capacitor $C_3$ is connected to the clock generator (not shown) to receive the clock pulses. The source of the transistor $T_7$ and the gate of the transistors $T_6$ are connected to the node $N_C$. The drain of the transistor $T_6$ is connected to the source of the transistor $T_5$, and the gate and drain of the transistor $T_5$ are connected to a line for supplying a high voltage $V_{PP}$ of about 19 V. To the first comparator $COM_1$, a constant reference voltage $(V_{PP}-3)$ V which is about 16 V is applied. In other respects this embodiment is the same as that of the embodiment shown in Figure 2.

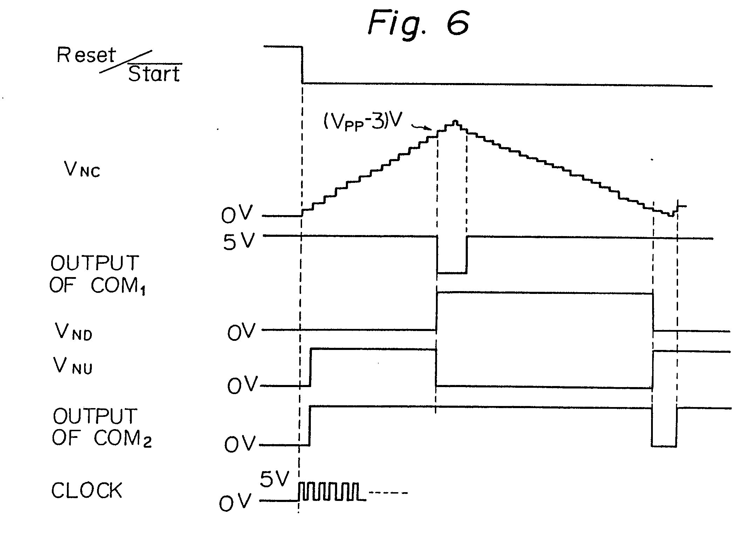

Figure 6 illustrates waveforms at various points in the embodiment in Figure 5. Hereinafter, the operation of the embodiment in Figure 5 will be explained with reference to Figure 6.

In response to the clock pulses, the voltage at the gate of the transistor $T_7$ momentarily increases and thus the transistor $T_7$ is intermittently turned on, causing a small charge from the line supplying the high voltage $V_{PP}$ to be pumped into the first MOS capacitor $C_1$. Therefore the first MOS capacitor $C_1$ is gradually charged, as shown in Figure 6. For example, the first MOS capacitor $C_1$ is charged by $\Delta Q_1$ in response to the clock pulse. When the voltage $V_{NC}$ exceeds $(V_{PP}-3)$ V,

which may be equal to 16 V, the output of the first comparator $COM_1$ changes from "H" level to "L" level, causing the output $V_{ND}$ of the flip-flop FF to change from "L" level to "H" level, as shown in Figure 6. As a result, the transistor $T_4'$ is turned on, causing a discharging operation of the first MOS capacitor $C_1$ to start. The first MOS capacitor $C_1$ is discharged by $\Delta Q_2$ in response to the clock pulse by the discharge circuit 10, and is charged by $\Delta Q_1$ in response to the clock pulse by the charge circuit 20'. Since the circuit is designed so that $\Delta Q_2 > \Delta Q_1$, the first MOS capacitor $C_1$ in fact is discharged by $\Delta Q_2 - \Delta Q_1$ in response to the clock pulse. Otherwise operation of this embodiment is the same as that of the embodiment shown in Figure 2.

According to the above embodiment, since the charge voltage is high (19 V), a MOS capacitor having a smaller capacitance than that in Figure 2 can be used for forming the timer having the same time interval. Furthermore, since not only the discharging operation but also the charging operation are executed very slowly, by intermittently turning on the transistor for transmitting charge, a timer having a longer time interval than that in Figure 2 can be formed.

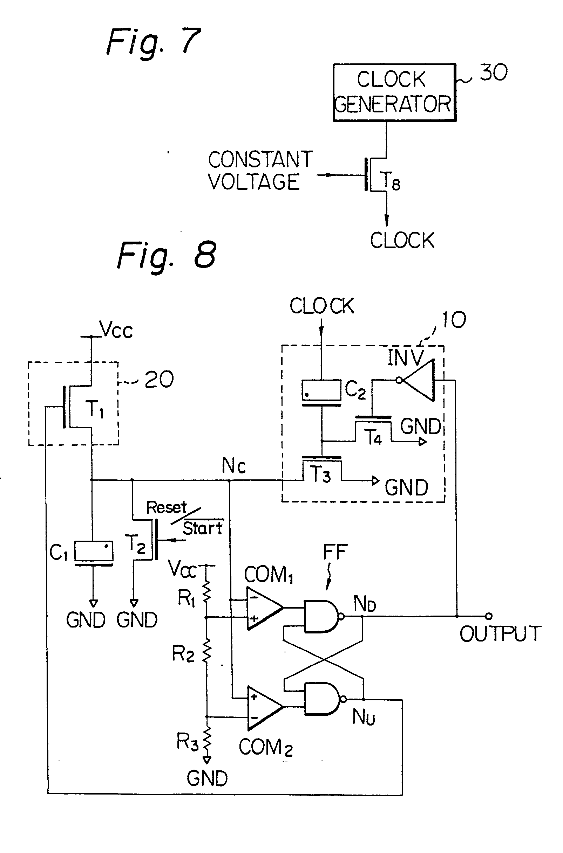

In the aforementioned embodiments, however, if the supply voltage $V_{CC}$ varies, the amplitude of the clock pulses will change, causing the time interval of the timer to change. Figure 7 illustrates an example of a circuit for preventing the above problem from occurring. In this example, a transistor $T_8$ is inserted between a clock generator 30 and the charge and/or discharge circuits, and a constant voltage of, for example, 4 V, is supplied to the gate of the transistor $T_8$. Therefore, the amplitude of the clock pulses is always maintained at a voltage of $(4-V_{th})$ V irrespective of any change in $V_{CC}$, where $V_{th}$ is a threshold voltage of the transistor $T_8$.

Figure 8 illustrates a further embodiment of the present invention. This embodiment also prevents the above-mentioned problem from occurring. In this embodiment, variable reference voltages are applied to the first and second comparators $COM_1$ and $COM_2$. The variable reference voltages are produced by dividing the power supply voltage $V_{CC}$ by means of resistors $R_1$, $R_2$, and $R_3$ connected in series to each other. Therefore, the voltage $V_{NC}$ for switching between the charging and discharging operations changes depending upon the power supply voltage $V_{CC}$, causing the change in time periods of the charging operation and the discharging operation owing to the charge in the $V_{CC}$ to be reduced. Otherwise, the constitution and operation of the embodiment shown in Figure 8 are the same as the those of the embodiment in Figure 2.

**Claims**

1. A semiconductor timer including: a first capacitor ($C_1$); a charge circuit (20, 20') connected to the first capacitor ($C_1$) for charging the first capacitor ($C_1$); and a discharge circuit (10) connected to the first capacitor (C$_1$) for discharging the first capacitor (C$_1$), the discharge circuit (10) including a first transistor (T$_3$) connected to the first capacitor (C$_1$) in parallel and having a gate; characterised in that the discharge circuit also includes a second capacitor (C$_2$) connected to the gate of the first transistor (T$_3$), and a second transistor (T$_4$, T'$_4$) connected either between the gate of the first transistor (T$_3$) and earth or to the terminal of the second capacitor (C$_2$) opposite the terminal connected to the gate of the first transistor, the second capacitor (C$_2$) receiving clock pulses and intermittently turning the first transistor (T$_3$) ON in response to the clock pulses to gradually discharge the first capacitor (C$_1$) in response to the clock pulses and in that the timer includes means (COM$_1$, FF) for monitoring a voltage across the first capacitor (C$_1$) and applying a first electrical signal to the gate of the second transistor (T$_4$, T'$_4$) to enable the clock pulses to start the discharge operation of the discharge circuit (10).

2. A semiconductor timer as claimed in claim 1, wherein the monitoring means (COM$_1$, COM$_2$, FF) also produces a second electrical signal used for starting the charging operation of the charge circuit (20, 20').

3. A semiconductor timer as claimed in claim 2, wherein the monitoring means includes means (COM$_1$, COM$_2$, FF) for judging whether the voltage across the first capacitor (C$_1$) becomes higher than an upper limit voltage and for judging whether the voltage across the first capacitor (C$_1$) becomes lower than a lower limit voltage.

4. A semiconductor timer as claimed in claim 3, wherein the judging means (COM$_1$, COM$_2$, FF) includes: a first comparator means (COM$_1$) for comparing the voltage across the first capacitor (C$_1$) with the upper limit voltage; a second comparator means (COM$_2$) for comparing the voltage across the first capacitor (C$_1$) with the lower limit voltage; and a bistable means (FF) connected to the first and second comparator means (COM$_1$, COM$_2$) for producing the first and second electrical signals in response to the outputs from the first and second comparator means (COM$_1$, COM$_2$).

5. A semiconductor timer as claimed in claim 2, 3 or 4 wherein the charge circuit (20) includes a third transistor (T$_1$), connected in series with the first capacitor (C$_1$), and wherein the second electrical signal is applied to the gate of the third transistor (T$_1$) to turn the third transistor (T$_1$) ON to apply a power supply voltage to the first capacitor (C$_1$).

6. A semiconductor timer as claimed in claim 1, wherein the charge circuit (20') includes a third transistor (T$_7$) connected in series with the first capacitor (C$_1$), and a further capacitor (C$_3$), the further capacitor (C$_3$) receiving clock pulses and intermittently turning the third transistor (T$_7$) ON to charge the first capacitor (C$_1$) in response to the clock pulses.

7. A semiconductor timer as claimed in claim 6, wherein the charge circuit (20') is operative during both charging and discharging of the first capacitor (C$_1$) and the discharge circuit (10) is operative only during discharging of the first capacitor (C$_1$), the increment of discharge per clock pulse being greater than the increment of charge per clock pulse.

**Patentansprüche**

1. Halbleiterzeitgeber mit: einem ersten Kondensator (C$_1$); einer Ladeschaltung (20, 20'), die mit dem ersten Kondensator (C$_1$) verbunden ist, um den ersten Kondensator (C$_1$) zu laden; und einer Entladeschaltung (10), die mit dem ersten Kondensator (C$_1$) verbunden ist, um den ersten Kondensator (C$_1$) zu entladen, welche Entladeschaltung (10) einen ersten Transistor (T$_3$) umfaßt, der mit dem ersten Kondensator (C$_1$) parallel verbunden ist und ein Gate hat; dadurch gekennzeichnet, daß die Entladeschaltung ferner einen zweiten Kondensator (C$_2$) enthält, der mit dem Gate des ersten Transistors (T$_3$) verbunden ist, und einen zweiten Transistor (T$_4$, T'$_4$), der entweder zwischen dem Gate des ersten Transistors (T$_3$) und Erde oder dem Anschluß des zweiten Kondensators (C$_2$) gegenüber dem Anschluß, der mit dem Gate des ersten Transistors verbunden ist, verbunden ist, welcher zweite Kondensator (C$_2$) Taktimpulse empfängt und intermittierend den ersten Transistor (T$_3$) EIN schaltet, in Abhängigkeit von den Taktimpulsen, um den ersten Kondensator (C$_1$) graduierlich in Abhängigkeit von den Taktimpulsen zu entladen, und daß der Zeitgeber Einrichtungen (COM$_1$, FF) zur Überwachung einer Spannung quer an dem ersten Kondensator (C$_1$) und zum Aufbringen eines ersten elektrischen Signals auf das Gate des zweiten Transistors (T$_4$, T'$_4$) umfaßt, um zu ermöglichen, daß die Taktimpulse den Entladebetrieb der Entladeschaltung (10) starten.

2. Halbleiterzeitgeber nach Anspruch 1, bei dem die Überwachungseinrichtung (COM$_1$, COM$_2$, FF) auch ein zweites elektrisches Signal erzeugt, das zum Starten des Ladebetriebs der Ladeschaltung (20, 20') verwendet wird.

3. Halbleiterzeitgeber nach Anspruch 2, bei dem die Überwachungseinrichtung Einrichtungen (COM$_1$, COM$_2$, FF) enthält, um zu beurteilen, ob die Spannung quer an dem ersten Kondensator (C$_1$) höher als die obere Grenzspannung wird, und um zu beurteilen, ob die Spannung quer an dem ersten Kondensator (C$_1$) niedriger als die untere Grenzspannung wird.

4. Halbleiterzeitgeber nach Anspruch 3, bei dem die Beurteilungseinrichtung (COM$_1$, COM$_2$, FF) umfaßt: eine erste Komparatoreinrichtung (COM$_1$), um die Spannung quer an dem ersten Kondensator (C$_1$) mit der oberen Grenzspannung zu vergleichen; eine zweite Komparatoreinrichtung (COM$_2$), um die Spannung quer an dem ersten Kondensator (C$_1$) mit der unteren Grenzspannung zu vergleichen; und eine bistabile Einrichtung (FF), die mit der ersten und zweiten Komparatoreinrichtung (COM$_1$, COM$_2$) verbunden ist, um erste und zweite elektrische Signale in Abhängigkeit von den Ausgängen von den ersten und zweiten Komparatoreinrichtungen (COM$_1$, COM$_2$) zu erzeugen.

5. Halbleiterzeitgeber nach Anspruch 2, 3 oder 4, bei dem die Ladeschaltung (20) einen dritten Transistor (T$_1$) umfaßt, der in Reihe mit dem ersten Kondensator (C$_1$) verbunden ist, und bei dem das zweite elektrische Signal dem Gate des dritten Transistors (T$_1$) zugeführt wird, um den dritten Transistor (T$_1$) auf EIN zu schalten, um auf den ersten Kondensator (C$_1$) eine Energieversorgungsspannung aufzubringen.

6. Halbleiterzeitgeber nach Anspruch 1, bei dem die Ladeschaltung (20') einen dritten Transistor (T$_7$) enthält, der in Reihe mit dem ersten Kondensator (C$_1$) verbunden ist, und einen weiteren Kondensator (C$_3$), wobei der weitere Kondensator (C$_3$) Taktimpulse empfängt und intermittierend den dritten Transistor (T$_7$) auf EIN schaltet, um den ersten Kondensator (C$_1$) in Abhängigkeit von den Taktimpulsen zu laden.

7. Halbleiterzeitgeber nach Anspruch 6, bei dem die Ladeschaltung (20) sowohl während des Ladens als auch des Entladens des ersten Kondensators (C$_1$) betreibbar ist, und die Entladeschaltung (10) lediglich während des Entladens des ersten Kondensators (C$_1$) betreibbar ist, und das Inkrement der Entladung pro Taktimpuls größer als das Inkrement der Ladung pro Taktimpuls ist.

**Revendications**

1. Temporisateur à semiconducteur, comportant: un premier condensateur (C$_1$); un circuit de charge (20, 20') connecté au premier condensateur (C$_1$), pour charger ce premier condensateur (C$_1$); et un circuit de décharge (10) connecté au premier condensateur (C$_1$) pour décharger ce premier condensateur (C$_1$), le circuit de décharge (10) comprenant un premier transistor (T$_3$) connecté au premier condensateur (C$_1$), en parallèle, et doté d'une grille; caractérisé en ce que le circuit de décharge comporte aussi un deuxième condensateur (C$_2$) connecté à la grille du premier transistor (T$_3$), et un deuxième transistor (T$_4$, T'$_4$) connecté entre la grille du premier transistor (T$_3$) et la terre ou à la borne du deuxième condensateur (C$_2$) opposée à la borne connectée à la grille du premier transistor, le deuxième condensateur (C$_2$) recevant des impulsions d'horloge et mettant par intermittence le premier transistor (T$_3$) à l'état passant, en réponse aux impulsions d'horloge, pour décharger graduellement le premier condensateur (C$_1$) en réponse aux impulsions d'horloge, et en ce que le temporisateur comporte des moyens (COM$_1$, FF) pour surveiller une tension aux bornes du premier condensateur (C$_1$) et appliquer un premier signal électrique à la grille du deuxième transistor (T$_4$, T'$_4$), pour permettre

aux impulsions d'horloge de faire démarrer l'opération de décharge du circuit de décharge (10).

2. Temporisateur à semiconducteur selon revendication 1, dans lequel les moyens de surveillance (COM$_1$, COM$_2$, FF) produisent aussi un deuxième signal électrique utilisé pour faire démarrer l'opération de charge du circuit de charge (20, 20').

3. Temporisateur à semiconducteur selon revendication 2, dans lequel les moyens de surveillance comprennent des moyens (COM$_1$, COM$_2$, FF) pour apprécier si la tension aux bornes du premier condensateur (C$_1$) devient plus grande qu'une tension-limite supérieure et pour apprécier si la tension aux bornes du premier condensateur (C$_1$) devient plus petite qu'une tension-limite inférieure.

4. Temporisateur à semiconducteur selon revendication 3, dans lequel les moyens d'appréciation (COM$_1$, COM$_2$, FF) comprennent: un premier moyen comparateur (COM$_1$) pour comparer la tension aux bornes du premier condensateur (C$_1$) à la tension-limite supérieure; un deuxième moyen comparateur (COM$_2$) pour comparer la tension aux bornes du premier condensateur (C$_1$) à la tension-limite inférieure; et un moyen bistable (FF) connecté au premier et au deuxième moyen comparateur (COM$_1$, COM$_2$) pour produire le premier et le deuxième signal électrique en réponse aux sorties provenant du premier et du deuxième moyen comparateur (COM$_1$, COM$_2$).

5. Temporisateur à semiconducteur selon revendication 2, 3 ou 4, dans lequel le circuit de charge (20) comprend un troisième transistor (T$_1$) connecté en série avec le premier condensateur (C$_1$), et dans lequel le deuxième signal électrique est appliqué à la grille du troisième transistor (T$_1$) pour mettre par intermittence ce troisième transistor (T$_1$) à l'état passant, pour appliquer une tension d'alimentation au premier condensateur (C$_1$).

6. Temporisateur à semiconducteur selon revendication 1, dans lequel le circuit de charge (20') comprend un troisième transistor (T$_7$) connecté en série avec le premier condensateur (C$_1$) et un autre condensateur (C$_3$), cet autre condensateur (C$_3$) recevant des impulsions d'horloge et mettant par intermittence le troisième transistor (T$_7$) à l'état passant, pour charger le premier condensateur (C$_1$) en réponse aux impulsions d'horloge.

7. Temporisateur à semiconducteur selon revendication 6, dans lequel le circuit de charge (20') opère aussi bien pendant la charge une pendant la décharge du premier condensateur (C$_1$), et le circuit de décharge (10) n'opère que pendant la décharge du premier condensateur (C$_1$), l'incrément de décharge par impulsion d'horloge étant plus grand que l'incrément de charge par impulsion d'horloge.

## Fig. 1a

CLOCK

$T_C$

$V_G$

TO NODE $N_C$   $T_T$   → GND

## Fig. 1b

CLOCK

$C_{TC}$

$V_G$

$C_{TT}$

GND

## Fig. 1c

CLOCK      $V_{CC}$

$V_G$

## Fig. 4

CLOCK

$T_4'$   FROM NODE $N_D$

$C_2$

TO GATE OF TRANSISTOR $T_3$

# Fig. 2

Fig. 3

## Fig. 5

Fig. 6

Reset / Start

$V_{NC}$

$(V_{PP}-3)V$

0V

OUTPUT OF $COM_1$

5V

$V_{ND}$

0V

$V_{NU}$

0V

OUTPUT OF $COM_2$

0V

CLOCK

5V

0V

EP 0 113 590 B1

## Fig. 7

## Fig. 8

6